# EUROPEAN PATENT APPLICATION

(11) **EP 2 290 417 A1**
(43) Date of publication of application: **02.03.2011**
(21) Application number: 10169601.1
(22) Date of filing: 15.07.2010
(51) Int. Cl.: G02B 6/42

(54) **Shielded optical transceiver**

(30) Priority: 28.08.2009 JP 2009197687
(71) Applicant: Alps Electric Co., Ltd., Tokyo 145-8501 (JP)
(72) Inventor: Watanabe, Yoshinori, Tokyo Tokyo 145-8501 (JP); Nakajima, Jiro, Tokyo Tokyo 145-8501 (JP)
(74) Representative: Klunker . Schmitt-Nilson . Hirsch

(57) **Abstract**

An optical transceiver includes a housing (10) provided with a plug holding an optical fiber, and a transceiver module (2) mounted on the housing (10) to receive and transmit an optical signal from and to the optical fiber. The housing (10) includes a plug connection section (11) connected to the plug, and a module mounting section (12) on which the transceiver module (2) is mounted. Surfaces of the housing (10) are covered by a first shield member (20) and a second shield member (30). The first shield member (20) has a surface facing the transceiver module (2) and a first elastic part (27) formed on the surface to press one surface directed to an outer side. The second shield member (30) has a second elastic part (28) that makes elastic contact with the first elastic part (27) to press the first elastic part (27) toward the transceiver module (2).

## Description

### Cross Reference to Related Application

The present invention contains subject matter related to Japanese Patent Application JP 2009-197687 filed in the Japanese Patent Office on August 28, 2009, the entire contents of which being incorporated herein by reference.

### BACKGROUND

### 1. Technical Field

The present disclosure relates to an optical connector that couples a transceiver module for receiving and transmitting an optical signal to an optical fiber. More particularly, the present disclosure relates to an optical connector provided with a shield member for protecting a transceiver module.

### 2. Related Art

According to the related art, at the time of optical communication, an optical connector is used for connecting an apparatus, which performs communication, to an optical network. The optical connector has a housing connected to a plug holding an optical fiber. A transceiver module for receiving an optical signal from the optical fiber and a transceiver module for transmitting an optical signal to the optical fiber are mounted on the housing.

Preferably, in such an optical connector, the transceiver module is covered by a shield member made of a metal material such that the transceiver module is not affected by the influence of external noise. For example, such an optical connector is disclosed in Japanese Unexamined Patent Application Publication No. 2009-111114.

The optical connector having the transceiver module covered by the shield member generally employs a configuration in which the transceiver module is pressed by the shield member so as to be press-fitted into the housing. In such a case, a notch having a substantially U shape and the like is formed in the shield member, and the inside of the shield member is employed as an elastic section having a leaf spring shape, in order that one surface of the transceiver module is elastically pressed by the front end of the elastic section.

When the elastic section is formed in a part of the shield member to press the transceiver module, variation occurs in the pressing force of the elastic section applied to the transceiver module due to an error in the dimensions of the transceiver module, an error in the dimensions of a spring shape, an assembly error of the shield member with respect to the housing, and the like. When the predetermined pressing force is not applied to the transceiver module, the positional accuracy of the transceiver module may not be sufficiently ensured. In this regard, in order to reliably perform optical communication, it is necessary to reduce variation in the pressing force applied to the transceiver module.

### SUMMARY

An advantage of some aspects of the present disclosure is to provide an optical connector capable of reducing the influence of variation in the pressing force when a transceiver module is press-fitted by an elastic section of a shield member.

According to an aspect of the present disclosure, there is provided an optical connector including: a housing provided with a plug holding an optical fiber; and a transceiver module mounted on the housing to receive an optical signal transmitted through the optical fiber or transmit an optical signal to the optical fiber, wherein the housing includes: a plug connection section connected to the plug; and a module mounting section on which the transceiver module is mounted, one surface of the transceiver module, which is mounted on the module mounting section, being directed to an outer side, wherein surfaces of the housing are covered by a first shield member and a second shield member which have conduction, wherein the first shield member has an opposite surface facing the transceiver module and a first elastic part formed on the surface to press one surface directed to an outer side of the transceiver module, and wherein the second shield member has a second elastic part that makes elastic contact with the first elastic part to press the first elastic part toward the transceiver module.

Further, in the optical connector according to the present disclosure, the first elastic part is formed as a cantilever-shaped leaf spring by cutting the opposite surface facing the transceiver module of the first shield member, and a front end of the first elastic part presses the transceiver module.

Furthermore, in the optical connector according to the present disclosure, the second elastic part makes elastic contact with the front end of the first elastic part and closes at least a part of a notch formed in the opposite surface resulting from the formation of the first elastic part.

In addition, in the optical connector according to the present disclosure, the second elastic part of the second shield member is inserted into a gap between a side surface of the transceiver module of the opposite surface of the first shield member and an external side surface of the first elastic part of the first shield member.

Moreover, in the optical connector according to the present disclosure, the first elastic part is provided at the front end thereof with a first protrusion having a convex shape protruding toward the transceiver module, and the second elastic part is provided with a second protrusion having a convex shape toward the first elastic part at a portion making elastic contact with the first elastic part.

According to the optical connector in accordance with the present disclosure, the surfaces of a housing are covered by a first shield member and a second shield member which have conduction, the first shield member has a surface facing the transceiver module and a first elastic part formed on the surface to press one surface directed to an outer side of the transceiver module, and the second shield member has a second elastic part that makes elastic contact with the first elastic part to press the first elastic part toward the transceiver module. Consequently, the second elastic part overlaps the first elastic part to press the first elastic part, so that pressing force of the first elastic part applied to the transceiver module may have a predetermined magnitude or more, and any influence due to variation of the pressing force may be reduced.

Further, according to the optical connector in accordance with the present disclosure, the first elastic part is formed as a cantilever-shaped leaf spring by cutting an opposite surface facing the transceiver module of the first shield member, and a front end of the first elastic part presses the transceiver module. Consequently, the first elastic part may be integrally formed with the first shield member, and the number of parts may be reduced.

Furthermore, according to the optical connector in accordance with the present disclosure, the second elastic part makes elastic contact with the front end of the first elastic part and closes at least a part of a notch formed in the opposite surface resulting from the formation of the first elastic part. Consequently, since a gap in the first shield member may be reduced, so that the shielding effect may be improved.

In addition, according to the optical connector in accordance with the present disclosure, the second elastic part of the second shield member is inserted into a gap between a side surface of the transceiver module facing the opposite surface of the first shield member and an external side surface of the first elastic part of the first shield member. Consequently, the gap of the first shield member may be closed by the second elastic part, and the first elastic part is reliably pressed in order that the transceiver module may be firmly pressed.

Moreover, according to the optical connector in accordance with the present disclosure, the first elastic part is provided at the front end thereof with a first protrusion having a convex shape protruding toward the transceiver module, and the second elastic part is provided with a second protrusion having a convex shape toward the first elastic part at a portion making elastic contact with the first elastic part. Consequently, force may be reliably transferred to the transceiver module by the first protrusion and the second protrusion.

### BRIEF DESCRIPTION OF THE DRAWINGS

Fig. 1 is an exploded perspective view of an optical connector according to the present embodiment.
Fig. 2 is an exploded side view of an optical connector when viewed in the arrow II direction of Fig. 1.
Fig. 3 is a sectional view illustrating an optical connector in an assembled state and corresponds to a sectional view taken along line IV-IV shown in Fig. 2.
Fig. 4 is a sectional view illustrating an optical connector in the assembled state and corresponds to a sectional view taken along line VI-VI shown in Fig. 3.
Fig. 5 is an enlarged front view illustrating the vicinity of a first elastic part when a first shield member and a second shield member are mounted on a housing.

### DESCRIPTION OF EXEMPLARY EMBODIMENTS

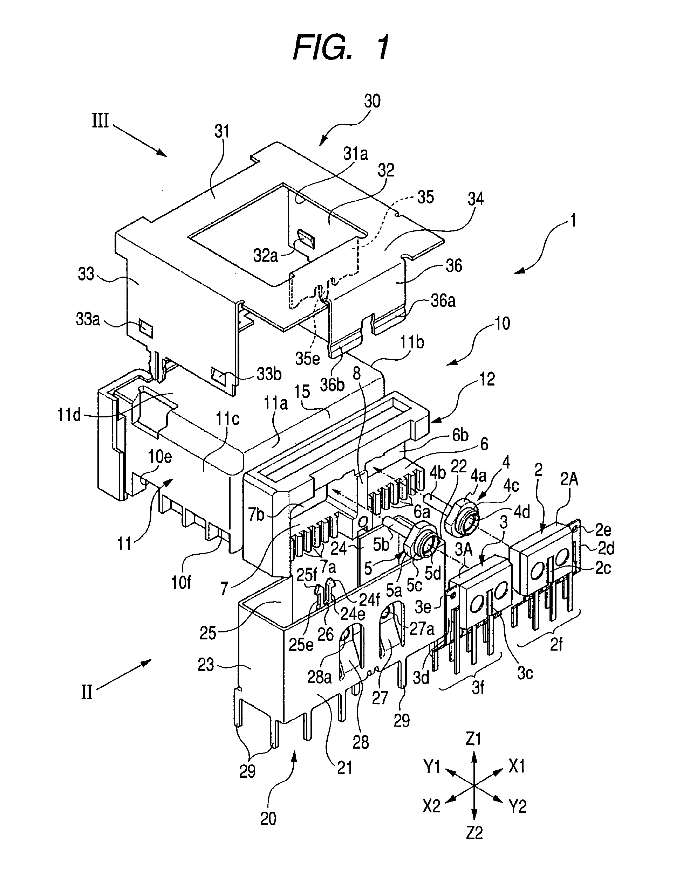

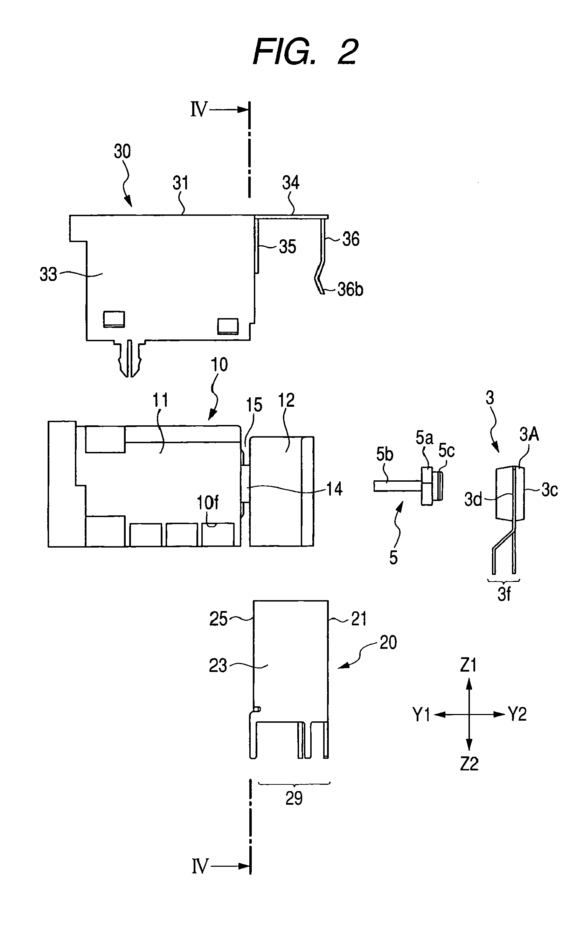

Hereinafter, an embodiment in accordance with the invention will be described in detail with reference to the accompanying drawings. Fig. 1 is an exploded perspective view of an optical connector according to the present embodiment and Fig. 2 is an exploded side view of the optical connector when viewed in the arrow II direction of Fig. 1. The optical connector 1 according to the embodiment is used as a receptacle, and transceiver modules 2 and 3 are mounted on a non-conductive housing 10 made of synthetic resin. One of the transceiver modules 2 and 3 serves as a light emitting module and the other of the transceiver modules 2 and 3 serves as a light receiving module. Furthermore, the housing 10 holds a coupling device 4 facing the transceiver module 2 and a coupling device 5 facing the transceiver module 3.

A plug holding two optical fibers is mounted on the housing 10. The plug is mounted on the housing 10, in order that a core of one of the two optical fibers is optically coupled to the transceiver module 2 through the coupling device 4, and a core of the other of the two optical fibers is optically coupled to the transceiver module 3 through the coupling device 5.

The housing 10 is divided into a plug connection section 11 and a module mounting section 12. The plug connection section 11 is connected to the module mounting section 12 through two connection sections 13 and 14. Furthermore, a portion, except for the connection section 14, between the plug connection section 11 and the module mounting section 12 of the housing 10 is an empty space and serves as a groove portion 15. The plug connection section 11, the module mounting section 12, and the connection sections 13 and 14 are integrally formed with one another by using a synthetic resin material such that they are not separated from one another.

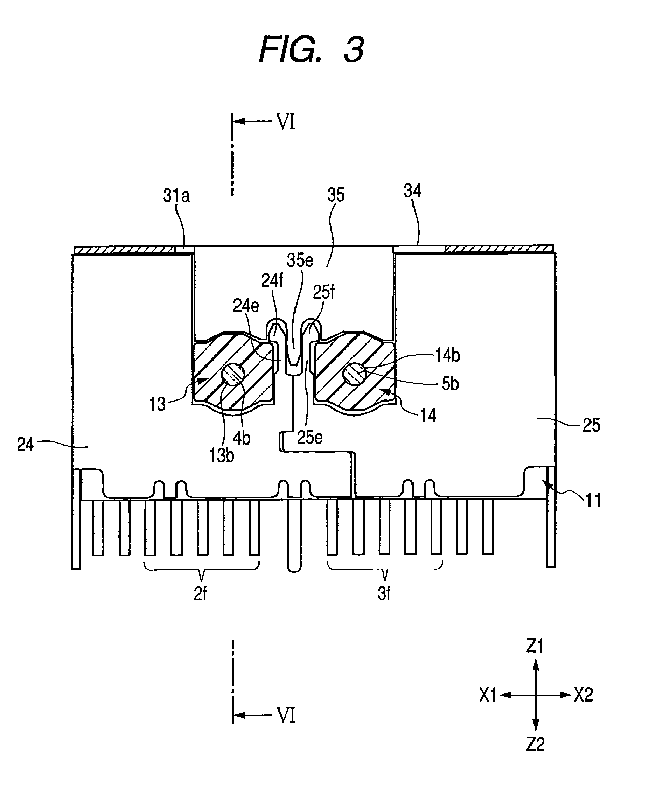

Fig. 3 is a sectional view illustrating the optical connector in an assembled state and corresponds to a sectional view taken along line IV-IV shown in Fig. 2. As shown in Fig. 3, the connection section 13 is formed at the center portion thereof with a coupling hole 13b and the connection section 14 is formed at the center portion thereof with a coupling hole 14b. The coupling hole 13b formed in the center portion of the connection section 13 extend therethrough in the forward and backward direction (Y1-Y2 direction) to communicate with the plug connection section 11 and the module mounting section 12. Similarly to this, the coupling hole 14b formed in the center portion of the connection section 14 extend therethrough in the forward and backward direction (Y1-Y2 direction) to communicate with the plug connection section 11 and the module mounting section 12.

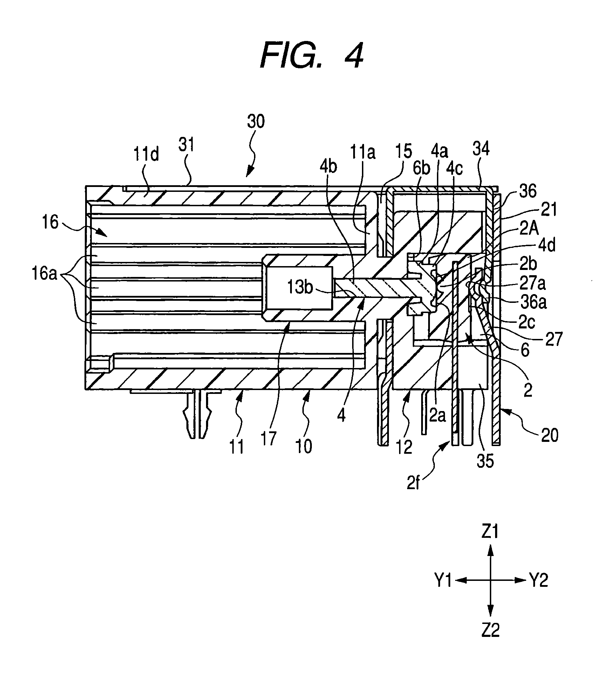

Fig. 4 is a sectional view illustrating the optical connector in the assembled state and corresponds to a sectional view taken along line VI-VI shown in Fig. 3. As shown in Fig. 4, a plug mounting concave section 16 is formed in the plug connection section 11 of the housing 10. A plurality of fitting ribs 16a extending forward and backward are formed in an inner surface of a sidewall 11b of the plug mounting concave section 16, and the plug holding the optical fibers has an outer side surface matching with the inner side surface of the plug mounting concave section 16 of the housing 10, and is provided with a convex section in correspondence with the fitting ribs 16a. Thus, the plug can be inserted into the plug mounting concave section 16 so as to be firmly fixed to the plug mounting concave section 16.

A fiber socket 17 extending forward (Y1 direction) from a rear sidewall 11a is integrally formed with the inside of the plug mounting concave section 16 to hold and fix an end portion of the optical fiber held by the plug.

Mounting concave sections 6 and 7 opened backward (Y2 direction) are formed in the module mounting section 12 of the housing 10. The mounting concave section 6 is formed in the X1 direction and the mounting concave section 7 is formed in the X2 direction. The mounting concave section 6 is separated from the mounting concave section 7 by a partition wall 8. The sectional view of Fig. 4 shows the mounting concave section 6 formed in the X1 direction. The mounting concave section 6 is opened backward (Y2 direction) and in the X1 direction, and the side in the Y1 direction of the mounting concave section 6 is closed by an inner wall surface 6b. The coupling hole 13b extending through the connection section 13, which is formed in the X1 direction, in the forward and backward direction communicates with the inside of the mounting concave section 6. The mounting concave section 7 formed in the X2 direction is opened only backward (Y2 direction) and the side in the Y1 direction of the mounting concave section 7 is closed by an inner wall surface 7b. The coupling hole 14b extending through the connection section 14, which is formed in the X2 direction, in the forward and backward direction communicates with the inside of the mounting concave section 7.

As shown in Fig. 1, the mounting concave section 6 formed in the X1 direction is formed at the lower portion thereof with a plurality of terminal insertion grooves 6a. Similarly to this, the mounting concave section 7 formed in the X2 direction is formed at the lower portion thereof with a plurality of terminal insertion grooves 7a.

The coupling device 4 is made of a transparent synthetic resin material (an optical resin material) and has a flange section 4a and a light guide section 4b linearly extending in the Y1 direction from the flange section 4a. A positioning link section 4c is formed at the side in the Y2 direction of the flange section 4a while being integrally formed with the flange section 4a, and a lens surface 4d is formed at the inside of the positioning link section 4c. The lens surface 4d is a spherical surface or an aspheric surface. Similarly to the coupling device 4, the coupling device 5 has a flange section 5a, a light guide section 5b, a positioning link section 5c and a lens surface 5d.

The coupling device 4 is mounted on the rear side of the mounting concave section 6 which is formed in the X1 direction. In detail, the coupling device 4 is positioned in such a manner that the light guide section 4b is inserted into the coupling hole 13b, and the flange section 4a makes contact with the inner wall surface 6b of the mounting concave section 6. Similarly to this, the coupling device 5 is mounted on the rear side of the mounting concave section 7 which is formed in the X2 direction. In detail, the coupling device 5 is positioned in such a manner that the light guide section 5b is inserted into the coupling hole 14b, and the flange section 5a makes contact with the inner wall surface 7b of the mounting concave section 7.

As shown in Fig. 4, the transceiver module 2 has a case 2A made of synthetic resin, and a positioning concave section 2a recessed in a circular shape is formed on the front surface of the case 2A, and a lens portion 2b is formed at the center of the positioning concave section 2a. A light receiving device or a light emitting device in the case 2A faces the lens surface 4d of the coupling device 4 through the lens portion 2b. As shown in Fig. 1, a terminal plate 2d is provided at the transceiver module 2 to protrude from the case 2A in the X1 direction, and is formed with a positioning hole 2e. A terminal group 2f, which includes terminals extending from the terminal plate 2d and a plurality of other terminals, protrudes from the lower side of the case 2A.

The transceiver module 3 is symmetrical to the transceiver module 2 in the X1-X2 direction. Although not shown in Fig. 4, a positioning concave section is formed on the front surface of a case 3A, and a lens portion is formed at the center of the positioning concave section. A light receiving device or a light emitting device in the case 3A faces the lens surface 5d of the coupling device 5 through the lens portion. As shown in Fig. 1, a terminal plate 3d is provided at the transceiver module 3 to protrude from the case 3A in the X2 direction, and a positioning hole 3e is opened in the terminal plate 3d. Furthermore, a terminal group 3f, which includes a plurality of terminals, protrudes downward from the case 3A.

As shown in Fig. 4, in relation to the transceiver module 2 mounted in the mounting concave section 6 formed in the X1 direction, the positioning link section 4c of the coupling device 4 is fitted into the positioning concave section 2a on the front surface of the case 2A, and a positioning protrusion (not shown) in the mounting concave section 6 is fitted into the positioning hole 2e formed in the terminal plate 2d, so that the transceiver module 2 is positioned. Consequently, the transceiver module 2 is arranged such that one surface 2c of the transceiver module 2 is directed to the outer side of the housing 10. Furthermore, the terminals of the terminal group 2f are inserted into the terminal insertion grooves 6a formed in the lower portion of the mounting concave section 6.

Simultaneously to this, in relation to the transceiver module 3 mounted in the mounting concave section 7 formed in the X2 direction, the positioning link section 5c of the coupling device 5 is fitted into the positioning concave section formed on the front surface of the case 3A, and a positioning protrusion (not shown) in the mounting concave section 7 is fitted into the positioning hole 3e formed in the terminal plate 3d, so that the transceiver module 3 is positioned. Consequently, the transceiver module 3 is arranged such that one surface 3c of the transceiver module 3 is directed to the outer side of the housing 10. Furthermore, the terminals of the terminal group 3f are inserted into the terminal insertion grooves 7a.

As shown in Fig. 1, a first shield member 20 is mounted on the module mounting section 12 of the housing 10 from the lower side of the module mounting section 12. The first shield member 20 is made of a conductive metal plate. Furthermore, a ground terminal group 29, which includes a plurality of ground terminals protruding downward from the lower end of the first shield member 20, is integrally formed with the first shield member 20.

As shown in Fig. 1, the first shield member 20 has a rear external shield section 21 formed in the Y2 direction. A right external shield section 22 is bent at a right angle in the Y1 direction from the end portion in the X1 direction of the rear external shield section 21, and a left external shield section 23 is bent at a right angle in the Y1 direction from the end portion in the X2 direction of the rear external shield section 21. A right boundary shield section 24 is bent at a right angle in the X2 direction from the front end in the Y1 direction of the right external shield section 22, and a left boundary shield section 25 is bent at a right angle in the X1 direction from the front end in the Y1 direction of the left external shield section 23.

In the first shield member 20, the right boundary shield section 24 and the left boundary shield section 25 are parallel to the rear external shield section 21 in the forward and backward direction (Y1-Y2 direction) while facing the rear external shield section 21, and the right external shield section 22 is parallel to the left external shield section 23 in the transverse direction (the X1-X2 direction) while facing the left external shield section 23.

An elastically deformable locking piece 24e extending upward (Z1 direction) is formed at the right boundary shield section 24, and a hook portion 24f protruding in the X1 direction is integrally formed with the upper end of the locking piece 24e. Furthermore, an elastically deformable locking piece 25e extending upward is formed at the left boundary shield section 25, and a hook portion 25f protruding in the X2 direction is integrally formed with the upper end of the locking piece 25e. As shown in Fig. 3, when the first shield member 20 and a second shield member 30 are mounted on the housing 10, the hook portions 24f and 25f are engaged with an intervening engagement piece 35e of the second shield member 30. The fixing method of the first shield member 20 is not limited to the above method. For example, locking claws, which are the same as a locking claw 32a, are provided at the right external shield section 22 and the left external shield section 23, concave portions are formed at the ends in the Z1 direction of both side surfaces in the X1 and X2 directions of the module mounting section 12, and the locking claws are fitted into the concave portions, so that the first shield member 20 may also be fixed to the housing 10.

As shown in Fig. 1, the rear external shield section 21, which is an opposite surface facing the transceiver modules 2 and 3 of the first shield member 20, is formed with two notches on the right and left having a substantially reverse U-shape. Inner portions of the two notches are formed as first and second elastic parts 27 and 28 serving as a cantilever-shaped leaf spring. The first and second elastic parts 27 and 28 are bent such that root portions of the first and second elastic parts 27 and 28 are inclined toward the transceiver modules 2 and 3, and are elastically deformable in the forward and backward direction (the Y1-Y2 direction). Furthermore, the first and second elastic parts 27 and 28 are provided at the front ends thereof with first protrusions 27a and 28a having a convex shape protruding in the Y1 direction.

According to the present embodiment, the substantially reverse U-shaped notches in the rear external shield section 21 allows the first and second elastic parts 27 and 28 to serve as the cantilever-shaped leaf spring by, so that the first and second elastic parts 27 and 28 can be integrally formed with the first shield member 20 and separate parts for the elastic parts are not required. In addition, the shape of the notch is not limited to the reverse U-shape. For example, the notch may have a U or V shape, and may have any shape if it can be used for forming the cantilever-shaped leaf spring.

As shown in Fig. 1, the second shield member 30 is mounted on the housing 10 from the top. The second shield member 30 is made of a conductive metal plate similarly to the first shield member 20.

The second shield member 30 has an upper holding shield member 31, a right holding shield member 32 bent at a right angle in the Z2 direction from the end portion in the X1 direction of the upper holding shield member 31, and a left holding shield member 33 bent at a right angle in the Z2 direction from the end portion in the X2 direction of the upper holding shield member 31. The upper holding shield member 31, the right holding shield member 32 and the left holding shield member 33 are integrally formed with one another.

As shown in Fig. 1, the left holding shield member 33 of the second shield member 30 is provided with a pair of locking claws 33a and 33b obtained by cutting a part of the left holding shield member 33 and bending the cut part inward. Similarly to this, the right holding shield member 32 is provided with a locking claw 32a obtained by cutting a part of the right holding shield member 32 and bending the cut part inward. If the second shield member 30 is mounted on the housing 10 in the Z2 direction, the left holding shield member 33 slides along the surface of a sidewall 11c in the X2 direction of the plug connection section 11, so that the locking claw 33a is locked with a concave portion 10e formed at the lower portion of the sidewall 11c, and the locking claw 33b is locked with a concave portion 10f formed at the lower portion of the sidewall 11c. Similarly to this, the left holding shield member 33 slides along the surface of a sidewall 11b in the X1 direction of the plug connection section 11, so that the locking claw 32a is locked with a concave portion formed at the lower portion of the sidewall 11b. Consequently, the second shield member 30 is fixed to the housing 10.

The upper holding shield member 31 is formed with an opening 31a having a rectangular shape, and an upper external shield member 34 is located further in the Y2 direction than the opening 31a while being integrally formed with the upper holding shield member 31. If the second shield member 30 is fixed to the housing 10, the upper holding shield member 31 is seated on the upper surface of an upper wall 11d of the plug connection section 11, and the upper external shield member 34 makes close contact with the upper surface of the module mounting section 12. Almost all of the region of the upper surface of the module mounting section 12 is covered by the upper external shield member 34.

Furthermore, in the second shield member 30, a central boundary shield member 35, which is continuous to a peripheral portion in the Y1 direction of the upper external shield member 34 and is bent from a peripheral portion of the opening 31a in the Z2 direction, is integrally formed with the upper external shield member 34. An intervening engagement piece 35e is integrally formed with the central boundary shield member 35 to protrude downward from the central boundary shield member 35.

Moreover, in the second shield member 30, a second elastic section 36, which is bent downward from a peripheral portion in the Y2 direction of the upper external shield member 34, is integrally formed with the upper external shield member 34. Second protrusions 36a and 36b are provided at the lower portion of the second elastic section 36 while being integrally formed with the second elastic section 36. The second protrusions 36a and 36b have a convex shape protruding toward the Y1 direction.

As shown in Fig. 4, in the state in which the first shield member 20 and the second shield member 30 are mounted on the housing 10, the first shield member 20 enters into the groove portion 15 of the housing 10. Furthermore, the transceiver module 2 is arranged such that one surface 2c of the transceiver module 2 is directed to the outer side of the housing 10.

Since the first elastic part 27 of the first shield member 20 is elastically bent to be inclined toward the transceiver module 2 as described above, the first protrusion 27a of the front end of the first elastic part 27 makes contact with the one surface 2c directed to the outer side of the transceiver module 2, so that the first elastic part 27 presses the transceiver module 2 in the Y1 direction.

The second elastic section 36 of the second shield member 30 is inserted into a gap between the housing 10 and the rear external shield section 21 of the first shield member 20. As described above, the second elastic section 36 of the second shield member 30 is provided at the lower portion thereof with the second protrusion 36a with a convex shape, and the second elastic section 36 makes elastic contact with the first elastic part 28 through the second protrusion 36a. Consequently, the second elastic section 36 presses the first elastic part 28 toward the transceiver module 2.

In this way, since the front end of the first elastic part 28 overlaps the front end of the second elastic section 36 and presses the one surface 2c, which is directed to the outer side of the transceiver module 2, by the second elastic section 36, even if variation occurs in the pressing force of the first elastic part 28 applied to the transceiver module 2 due to an error in dimensions, an assembly error and the like, the transceiver module 2 can be reliably pressed by force of a predetermined magnitude or more and can be stably press-fitted.

The front end of the second elastic section 36 of the second shield member 30 is inserted into a gap between the side surface of the transceiver module 2 in the rear external shield section 21 of the first shield member 20 and the external side surface of the first elastic part 28 of the first shield member 20. Consequently, a part of the notches formed in the rear external shield section 21 is closed from the inside.

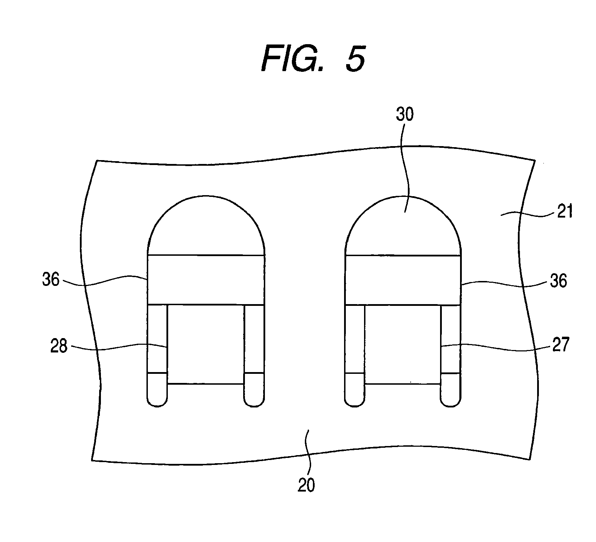

Fig. 5 is an enlarged front view illustrating the vicinity of the first elastic part 28 when the first shield member 20 and the second shield member 30 are mounted on the housing 10. As shown in Fig. 5, in the state in which the first shield member 20 and the second shield member 30 are mounted on the housing 10, the upper halves of the reverse U-shaped notches of the rear external shield section 21, which are formed by the provision of the first elastic parts 27 and 28, are closed by the front end of the second elastic section 36. Consequently, the notches of the first shield member 20 are closed by the second elastic section 36, so that the shield effect for the transceiver modules 2 and 3 can be improved.

It should be understood by those skilled in the art that various modifications, combinations, sub-combinations and alterations may occur depending on design requirements and other factors insofar as they are within the scope of the appended claims or the equivalents thereof.

## Claims

1. An optical connector comprising:
a housing (10) provided with a plug holding an optical fiber; and
a transceiver module (2) mounted on the housing (10) to receive an optical signal transmitted through the optical fiber or transmit an optical signal to the optical fiber,
wherein the housing (10) comprises:
a plug connection section (11) connected to the plug; and
a module mounting section (12) on which the transceiver module (2) is mounted, one surface of the transceiver module (2), which is mounted on the module mounting section (12), being directed to an outer side,
wherein surfaces of the housing (10) are covered by a first shield member (20) and a second shield member (30) which have conduction,
wherein the first shield member (20) has an opposite surface facing the transceiver module (2) and a first elastic part (27) formed on the surface to press one surface directed to an outer side of the transceiver module (2), and
wherein the second shield member (30) has a second elastic part (28) that makes elastic contact with the first elastic part (27) to press the first elastic part (27) toward the transceiver module (2).

2. The optical connector according to claim 1, wherein the first elastic part (27) is formed as a cantilever-shaped leaf spring by cutting an opposite surface facing the transceiver module (2) of the first shield member (20), and a front end of the first elastic part (27) presses the transceiver module (2).

3. The optical connector according to claim 2, wherein the second elastic part (28) makes elastic contact with the front end of the first elastic part (27) and closes at least a part of a notch formed in the opposite surface resulting from the formation of the first elastic part (27).

4. The optical connector according to claim 3, wherein the second elastic part (28) of the second shield member (30) is inserted into a gap between a side surface of the transceiver module (2) facing the opposite surface of the first shield member (20) and an external side surface of the first elastic part (27) of the first shield member (20).

5. The optical connector according to any one of claims 2 to 4, wherein the first elastic part (27) is provided at the front end thereof with a first protrusion (27a) having a convex shape protruding toward the transceiver module (2), and the second elastic part (28) is provided with a second protrusion (28a) having a convex shape toward the first elastic part (27) at a portion making elastic contact with the first elastic part (27).
